# EUROPÄISCHE PATENTSCHRIFT

(11) **EP 2 750 838 B1**
(45) Veröffentlichungstag und Bekanntmachung des Hinweises auf die Patenterteilung: **13.03.2019**
(21) Anmeldenummer: 12728557.5
(22) Anmeldetag: 20.06.2012
(51) Int. Cl.: B25F 5/00, H01M 10/44

(54) **VERFAHREN UND VORRICHTUNG ZUR STROMÜBERWACHUNG EINER DURCH EINE BATTERIE BETRIEBENEN HANDWERKZEUGMASCHINE**
METHOD AND DEVICE FOR MONITORING THE CURRENT OF A HAND-POWER TOOL DRIVEN BY A BATTERY
PROCÉDÉ ET DISPOSITIF DE SURVEILLANCE DU COURANT POUR UNE MACHINE-OUTIL MANUELLE FONCTIONNANT SUR UNE BATTERIE

(30) Priorität: 30.08.2011 DE 102011081790
(43) Veröffentlichungstag der Anmeldung: 09.07.2014
(73) Patentinhaber: HILTI Aktiengesellschaft, 9494 Schaan (LI)
(72) Erfinder: BRANDNER, Michael, 86899 Landsberg am Lech (DE); MÜLLER, Thomas, 86836 Klosterlechfeld (DE); ZIEGLER, Bernd, 86856 Hiltenfingen (DE)
(74) Vertreter: Hilti Aktiengesellschaft Corporate Intellectual Property
(86) Internationale Anmeldenummer: PCT/EP2012/061766
(87) Internationale Veröffentlichungsnummer: WO 2013/029825

(56) Entgegenhaltungen:
- US-A- 6 087 815
- US-A1- 2005 077 878

## Beschreibung

### GEBIET DER ERFINDUNG

Die vorliegende Erfindung betrifft ein Verfahren und eine Vorrichtung zur Stromüberwachung eines durch eine Batterie betriebenen Handwerkzeugmaschine, sowie in US 6 087 815 A dargestellt ist. Das elektrische Gerät ist zum Beispiel ein Elektroschrauber oder eine Akku-Handkreissäge.

Als Batterien in Handwerkzeugen werden wiederaufladbare Batterien, Sekundärbatterien oder Akkumulatoren eingesetzt. Die Batterie hat insbesondere eine Vielzahl wiederaufladbarer Batteriezellen, zum Beispiel Lithium-Ionen-Akkuzellen. Zur Steigerung der Lebensdauer werden herkömmlicherweise ein Tiefentladeschutz, ein Übertemperaturschutz und ein Überstromschutz, zum Beispiel bei Überlastung oder Blockieren des Gerätes, eingesetzt.

Der herkömmliche Überlastschutz oder Überstromschutz überwacht den von der Batterie entnommenen Strom auf das Überschreiten einer definierten oder vorbestimmten Grenze für eine gewisse Zeitdauer, in diesem Fall erfolgt eine Abschaltung des Geräts. Diese vorbestimmte Grenze liegt herkömmlicherweise weit über dem normalen oder durchschnittlichen Arbeitsstrom des elektrischen Gerätes. Wenn der Anwender des elektrischen Gerätes dessen Schalter nach einer Auslösung/Abschaltung löst und erneut drückt, kann das Gerät wieder für die definierte Zeitdauer betrieben werden.

Insbesondere bei Lithium-Ionen-Akkuzellen sind aber nicht nur hohe Ströme für eine kurze Zeit negativ für die Lebensdauer, sondern bereits relativ niedrige Ströme können bei längeren Entladezyklen die Lebensdauer der Lithium-Ionen-Akkuzellen stark reduzieren. Die herkömmliche Stromüberwachung ist hierbei allerdings nicht zielführend, da der Anwender bereits nach kurzer Unterbrechung, insbesondere durch Lösen und erneutes Drücken des Schalters des Gerätes, für eine relativ lange Zeit das Gerät wieder in den hohen Strombereichen, von beispielsweise 70 bis 100 A, betreiben kann.

### OFFENBARUNG DER ERFINDUNG

Das erfindungsgemäße Verfahren zur Stromüberwachung eines durch eine Batterie betriebenen elektrischen Gerätes mittels zumindest eines Zählers umfasst folgende Schritte: Messen des von der Batterie entnommenen elektrischen Stroms während des Betriebs des elektrischen Gerätes, Inkrementieren eines Zählerstands des Zählers um ein bestimmtes Inkrement jeweils dann, wenn der gemessene Strom innerhalb eines bestimmten Zählintervalls größer als ein bestimmter oberer Grenzwert ist, Dekrementieren des Zählerstands des Zählers um ein bestimmtes Dekrement jeweils dann, wenn der gemessene Strom innerhalb des bestimmten Zählintervalls kleiner als der bestimmte obere Grenzwert ist und Abschalten des elektrischen Gerätes, wenn der Zählerstand des Zählers größer als ein bestimmter Zählergrenzwert ist.
Der Zählerstand des Zählers kann während des Betriebes des elektrischen Gerätes, sowie in einer definierten Selbsthaltezeit nach Loslassen des Schalters überwacht werden, wobei die Abschaltvorrichtung das Gerät bei Überschreiten der definierten Grenze, nämlich des bestimmten Zählergrenzwerts, abschaltet. Durch die erfindungsgemäße Stromüberwachung wird der Schutz der Batterie verbessert sowie die Lebensdauer verlängert. Ferner wird die Geräteleistung des elektrischen Gerätes in Folge der Lebens- und Leistungssteigerung der Batterie erhöht. Wird beispielsweise unmittelbar nach einer Abschaltung des Gerätes dieses mit erhöhtem Strom wieder weiter betrieben, so ist dies erfindungsgemäß nur für eine sehr kurze Zeit auf Grund des dann noch hohen Zählerstandes des Zählers möglich. Erst nach einer entsprechend langen Pause, in der der Zähler wieder dekrementiert wird, steht wieder der volle Zeitraum für das Betreiben des elektrischen Gerätes oberhalb des oberen Grenzwertes zur Verfügung. Solange der Zählerstand aber nicht Null geworden ist, steht dieser volle Zeitraum für den Betrieb des elektrischen Gerätes oberhalb der bestimmten oberen Grenze nicht zur Verfügung. Beispielsweise ist durch die erfindungsgemäße Stromüberwachung verhindert, dass der Anwender bereits nach kurzer Unterbrechung, beispielsweise durch Lösen und erneutem Drücken des Schalters, das Gerät für einen längeren Zeitraum bei hohen, insbesondere bei zu hohen Strombereichen von 70 A bis 100 A, betreiben kann.

Es wird eine Mehrzahl von Zählern bereitgestellt. Dem jeweiligen Zähler werden ein bestimmtes Inkrement, ein bestimmtes Dekrement, ein bestimmtes Zählintervall, ein bestimmter oberer Grenzwert und ein bestimmter Zählergrenzwert zugeordnet.
Beispielsweise können zwei Zähler bereitgestellt werden, wobei einem ersten Zähler ein geringerer oberer Grenzwert und dafür ein höherer Zählergrenzwert zugeordnet werden, und einem zweiten Zähler ein höherer oberer Grenzwert und dafür ein geringerer bestimmter Zählergrenzwert zugeordnet werden.

In einer weiteren Ausführungsform werden die folgenden Schritte für einen jeden Zähler der Mehrzahl von Zählern durchgeführt: Inkrementieren eines Zählerstands des Zählers um ein bestimmtes Inkrement jeweils dann, wenn der gemessene Strom innerhalb eines bestimmten Zählintervalls größer als ein bestimmter oberer Grenzwert ist, Dekrementieren des Zählerstands des Zählers um ein bestimmtes Dekrement jeweils dann, wenn der gemessene Strom innerhalb des bestimmten Zählintervalls kleiner als der bestimmte obere Grenzwert ist und Abschalten des elektrischen Gerätes, wenn der Zählerstand des Zählers größer als ein bestimmter Zählergrenzwert ist.

Folglich kann das elektrische Gerät schon dann abgeschaltet werden, wenn zumindest ein Zählerstand seinen zugeordneten bestimmten Zählergrenzwert überschreitet.

In einer weiteren Ausführungsform wird der Zählerstand des Zählers um zumindest das Doppelte des bestimmten Dekrements dekrementiert, wenn der gemessene Strom innerhalb des bestimmten Zählintervalls kleiner als ein bestimmter unterer Grenzwert ist.

Bei einer weiteren Ausführungsform wird der Zählerstand des Zählers um das Doppelte des bestimmten Dekrements dekrementiert, wenn der gemessene Strom innerhalb des bestimmten Zählintervalls kleiner als der untere Grenzwert und größer Null ist, und der Zählerstand des Zählers wird um das Dreifache des bestimmten Dekrements dekrementiert, wenn der gemessene Strom innerhalb des bestimmten Zählintervalls Null ist.

Der untere Grenzwert kann dem oberen Grenzwert entsprechen. Der untere Grenzwert kann aber auch zwischen dem oberen Grenzwert und Null liegen.

Bei einer weiteren Ausführungsform liegt das Zählintervall zwischen 0,25 ms und 50 ms. Die Batterie kann auch als wiederaufladbare Batterie, Sekundärbatterie oder Akkumulator bezeichnet werden. Die Batterie hat insbesondere eine Vielzahl wiederaufladbarer Batteriezellen, zum Beispiel Lithium-Ionen-Akkuzellen.

In einer weiteren Ausführungsform wird der obere Grenzwert in Abhängigkeit der C-Rate der Batterie bestimmt. Die C-Rate der Batterie ergibt sich aus dem Verhältnis zwischen Strom und Kapazität.

Weiterhin wird eine Vorrichtung zur Stromüberwachung eines durch eine Batterie betriebenen elektrischen Gerätes vorgeschlagen. Die Vorrichtung zur Stromüberwachung weist eine Messeinrichtung, zumindest einen Zähler und eine Abschaltvorrichtung auf. Die Messeinrichtung ist zum Messen des von der Batterie entnommenen elektrischen Stroms während des Betriebs des elektrischen Gerätes eingerichtet. Der zumindest eine Zähler ist dazu eingerichtet, seinen Zählerstand um ein bestimmtes Inkrement jeweils dann zu inkrementieren, wenn der gemessene Strom innerhalb eines bestimmten Zählintervalls größer als ein bestimmter oberer Grenzwert ist, und um ein bestimmtes Dekrement jeweils dann zu dekrementieren, wenn der gemessene Strom innerhalb des bestimmten Zählintervalls kleiner als der bestimmte obere Grenzwert ist. Die Abschaltvorrichtung schaltet das elektrische Gerät ab, wenn der Zählerstand des Zählers größer als ein bestimmter Zählergrenzwert ist.

Es ist eine Mehrzahl von Zählern vorgesehen. Dem jeweiligen Zähler werden ein bestimmtes Inkrement, ein bestimmtes Dekrement, ein bestimmtes Zählintervall, ein bestimmter oberer Grenzwert und ein bestimmter Zählergrenzwert zugeordnet. Die Abschaltvorrichtung schaltet das elektrische Gerät ab, wenn zumindest ein Zählerstand größer als sein bestimmter Zählergrenzwert ist.
Bei einer weiteren Ausführungsform ist der Zähler dazu eingerichtet, seinen Zählerstand um zumindest das Doppelte des bestimmten Dekrements zu dekrementieren, wenn der gemessene Strom innerhalb des bestimmten Zählintervalls kleiner als ein bestimmter unterer Grenzwert ist.
Bei einer weiteren Ausführungsform ist der Zähler dazu eingerichtet, seinen Zählerstand um das Doppelte des bestimmten Dekrements zu dekrementieren, wenn der gemessene Strom innerhalb des bestimmten Zählintervalls kleiner als der untere Grenzwert und größer Null ist, und um seinen Zählerstand um das Dreifache des bestimmten Dekrements zu dekrementieren, wenn der gemessene Strom innerhalb des bestimmten Zählintervalls Null ist.
Ferner wird eine Steuervorrichtung zum Steuern eines durch eine Batterie betriebenen elektrischen Gerätes vorgeschlagen, welche eine wie oben beschriebene Vorrichtung zur Stromüberwachung des elektrischen Gerätes aufweist.
Die Steuerungsvorrichtung ist beispielsweise als Teil der Elektronik des elektrischen Gerätes ausgebildet. Zum Beispiel ist die Steuerungsvorrichtung ein Microcontroller.

Des Weiteren wird ein elektrisches Gerät mit einer Batterie vorgeschlagen, welches eine wie oben beschriebene erfindungsgemäße Vorrichtung zur Stromüberwachung des elektrischen Gerätes aufweist.

Das elektrische Gerät ist beispielsweise eine Handwerkzeugmaschine. Die Handwerkzeugmaschine ist insbesondere eine elektrische Handwerkzeugmaschine, wie zum Beispiel ein Elektroschrauber.

Der Elektroschrauber hat ein Gehäuse mit einem Handgriff, mittels welchem ein Anwender den Elektroschrauber halten und führen kann. Ein Taster an dem Handgriff ermöglicht dem Anwender den Elektroschrauber in Betrieb zu nehmen. Beispielsweise muss der Anwender den Taster durchgehend gedrückt halten, um den Elektroschrauber in Betrieb zu halten.

Der Elektroschrauber hat eine Werkzeugaufnahme, in welche der Anwender z.B. ein Schrauberbit einsetzen kann. Bei Betätigen des Tasters dreht ein Elektromotor die Werkzeugaufnahme um ihre Achse. Der Elektromotor ist über eine Spindel und ggf. weitere Komponenten eines Antriebsstrangs, z.B. Kupplung, Getriebe, mit der Werkzeugaufnahme gekoppelt.

### KURZE BESCHREIBUNG DER FIGUREN

Die nachfolgende Beschreibung erläutert die Erfindung anhand von exemplarischen Ausführungsformen und Figuren. In den Figuren zeigt:
- Fig. 1: ein schematisches Ablaufdiagramm eines Verfahrens zur Stromüberwachung eines durch eine Batterie betriebenen elektrischen Gerätes;
- Fig. 2: ein I-t-Diagramm zur Darstellung eines ersten Beispiels eines Stromverlaufs;
- Fig. 3: ein Diagramm zur Darstellung eines ersten Zählers für den Stromverlauf der Fig. 2;
- Fig. 4: ein Diagramm zur Darstellung eines zweiten Zählers für den Stromverlauf der Fig. 2;
- Fig. 5: ein I-t-Diagramm zur Darstellung eines zweiten Beispiels eines Stromverlaufs;
- Fig. 6: ein Diagramm zur Darstellung eines ersten Zählers für den Stromverlauf der Fig. 5;
- Fig. 7: ein Diagramm zur Darstellung eines zweiten Zählers für den Stromverlauf der Fig. 5;
- Fig. 8: ein schematisches Blockschaltbild einer Vorrichtung zur Stromüberwachung eines durch eine Batterie betriebenen elektrischen Gerätes;
- Fig. 9: ein schematisches Blockschaltbild eines ersten Ausführungsbeispiels einer Vorrichtung zur Stromüberwachung eines durch eine Batterie betriebenen elektrischen Gerätes;
- Fig. 10: ein schematisches Blockschaltbild eines Ausführungsbeispiels einer Steuerungsvorrichtung eines elektrischen Gerätes, und
- Fig. 11: ein schematisches Blockschaltbild eines Ausführungsbeispiels eines elektrischen Gerätes.

Gleiche oder funktionsgleiche Elemente werden durch gleiche Bezugszeichen in den Figuren indiziert, soweit nicht anders angegeben.

### AUSFÜHRUNGSFORMEN DER ERFINDUNG

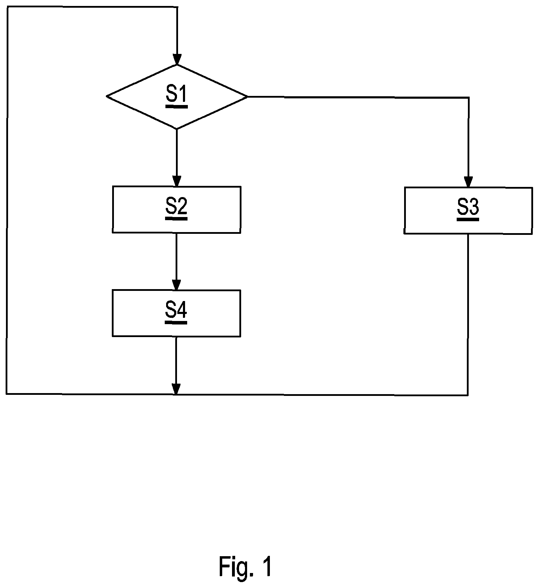

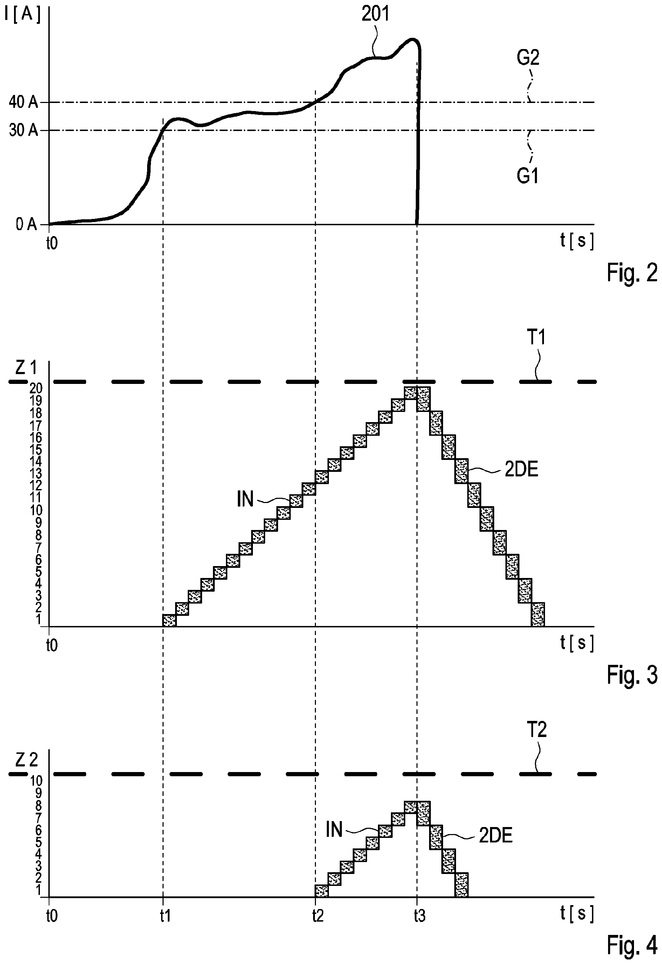

In Fig. 1 ist ein schematisches Ablaufdiagramm eines Verfahrens zur Stromüberwachung eines durch eine Batterie 2 betriebenen elektrischen Gerätes 3 dargestellt.
In Schritt S1 wird der von der Batterie 2 entnommene elektrische Strom I während des Betriebs des elektrischen Gerätes 3 gemessen. Insbesondere wird in einem jeden Zählintervall ein diskreter Wert des elektrischen Stroms I bereitgestellt.
Wenn der diskrete Wert des gemessenen Stroms I innerhalb des bestimmten Zählintervalls größer als ein bestimmter oberer Grenzwert G1, G2 ist, wird der Schritt S2 ausgeführt. Wenn allerdings der diskrete Wert des gemessenen Stroms I innerhalb des bestimmten Zählintervalls kleiner als der bestimmte obere Grenzwert G1, G2 ist, wird der Schritt S3 ausgeführt. In Schritt S2 wird der Zählerstand Z des Zählers 5 um ein bestimmtes Inkrement IN inkrementiert. Beispielsweise wird der Zähler 5 um 1 inkrementiert.
In Schritt S3 wird der Zählerstand Z des Zählers 5 um ein bestimmtes Dekrement DE dekrementiert, wenn - wie oben ausgeführt - der diskrete Wert für den gemessenen Strom I innerhalb des bestimmten Zählintervalls kleiner als der bestimmte obere Grenzwert G1, G2 ist. Folglich wird in jedem Zählintervall in Abhängigkeit des jeweils gemessenen Stroms I bestimmt, ob der Zählerstand Z des Zählers 5 inkrementiert (Schritt S2) oder dekrementiert (Schritt S3) wird.
In Schritt S4 wird das elektrische Gerät 3 abgeschaltet, wenn der Zählerstand Z des Zählers 5 größer als ein bestimmter Zählergrenzwert T1, T2 ist. Mit anderen Worten triggert das Überschreiten des Zählerstands Z über den bestimmten Zählergrenzwert T1, T2 das Abschalten des elektrischen Gerätes 3.
Insgesamt werden die Schritte S1 bis S4 der Fig. 4 in einem jeden Zählintervall durchgeführt. Das Zählintervall liegt beispielsweise zwischen 0,25 ms und 50 ms. Der obere Grenzwert G1, G2 wird insbesondere in Abhängigkeit der C-Rate der Batterie 2 bestimmt.

Eine Mehrzahl von Zählern 5 wird verwendet. Die unterschiedlichen Zähler 5 können mit unterschiedlichen Inkrementen IN, unterschiedlichen Dekrementen DE, unterschiedlichen bestimmten Zählintervallen, unterschiedlichen bestimmten oberen Grenzwerten G1, G2 und unterschiedlichen bestimmten Zählergrenzwerten T1, T2 eingesetzt werden.
Ferner ist es möglich, dass in Schritt S3 der Zählerstand Z des Zählers 5 um zumindest das Doppelt des bestimmten Dekrements DE dekrementiert wird, wenn der gemessene Strom I innerhalb des bestimmten Zählintervalls kleiner als ein bestimmter unterer Grenzwert ist. Der untere Grenzwert kann beispielsweise auch dem oberen Grenzwert G1, G2 entsprechen. Ferner ist es dabei auch möglich, den Zählerstand des Zählers 5 um das Doppelte 2DE des bestimmten Dekrements DE zu dekrementieren, wenn der gemessene Strom I innerhalb des bestimmten Zählintervalls kleiner als der untere Grenzwert und größer Null ist. Ist der gemessene Strom I innerhalb des bestimmten Zählintervalls aber Null, so kann der Zählerstand Z des Zählers 5 um das Dreifache des bestimmten Dekrements DE dekrementiert werden.

Zur weiteren Erläuterung des in Fig. 1 dargestellten Verfahrens zeigen die Fig. 2 bis 4 ein erstes Beispiel für einen Stromverlauf 201. Dabei zeigt die Fig. 2 ein I-T-Diagramm zur Darstellung des ersten Beispiels des Stromverlaufs 201. Weiter zeigt die Fig. 3 ein Diagramm zur Darstellung eines ersten Zählers Z1 für den Stromverlauf 201 der Fig. 2. Ferner zeigt die Fig. 4 ein Diagramm zur Darstellung eines zweiten Zählers Z2 für den Stromverlauf 201 der Fig. 2. Die x-Achsen der Fig. 2 bis 4 zeigen jeweils die Zeit t in s. Die Y-Achse der Fig. 2 zeigt den Strom I in A. Die y-Achse der Fig. 3 zeigt den Zählerstand Z1 des ersten Zählers 5. Entsprechend zeigt die y-Achse der Fig. 4 den Zählerstand Z2 des zweiten Zählers 5.

Der erste Zähler 5 gemäß der Fig. 3 hat einen ersten oberen Grenzwert G1 von 30 A für den Strom I (siehe Fig. 2) und einen Zählergrenzwert T1 von 20 (siehe Fig. 3). Der zweite Zähler 5 gemäß Fig. 4 hat einen zweiten oberen Grenzwert G2 von 40 A für den Strom I und einen Zählergrenzwert T2 von 10.

Zum Zeitpunkt t1 überschreitet der Stromverlauf 201 den Grenzwert G1. Damit beginnt der erste Zähler 5 ab dem Zeitpunkt t1 hochzuzählen. In jedem Zählintervall erhöht der erste Zähler 5 seinen Zählerstand Z1 um das zugeordnete bestimmte Inkrement IN, beispielsweise um 1.

Zum Zeitpunkt t2 überschreitet der Stromverlauf 201 die 40A und damit den zweiten Grenzwert G2. Folglich beginnt der zweite Zähler 5 seinen Zählerstand Z2 ab dem Zeitpunkt t2 zu inkrementieren. Insgesamt inkrementieren beide Zähler 5 der Fig. 3 und 4 ihre Zählerstände Z1, Z2 ab dem Zeitpunkt t2.

Zum Zeitpunkt t3 erreicht der erste Zählerstand Z1 gemäß Fig. 3 seinen bestimmten oberen Grenzwert G1 von 20.

Folglich wird das elektrische Gerät 3 zum Zeitpunkt t3 abgeschaltet, weil Z1 = T1. Ab dem Zeitpunkt t3 ist der gemessene Strom I Null. Folglich werden die Zählerstände Z1 und Z2 der beiden Zähler 5 der Fig. 3 und 4 um das jeweilige Dekrement DE dekrementiert. Beispielsweise ist das Dekrement DE jeweils 2 und damit doppelt so groß wie das Inkrement IN.

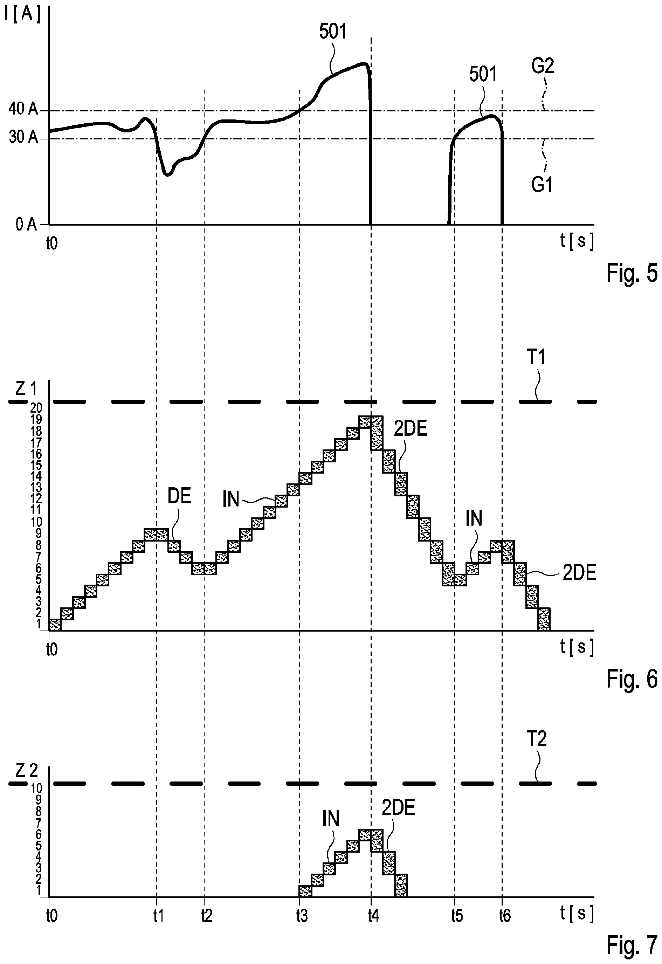

Ein weiteres Beispiel für einen Stromverlauf 501 des Stroms I ist in der Fig. 5 dargestellt. Analog zu den Fig. 3 und 4 zeigen die Fig. 6 und 7 einen ersten Zähler 5 mit einem ersten Zählerstand Z1 (Fig. 6) und einen zweiten Zähler 5 mit einem Zählerstand Z2.

Zum Zeitpunkt t0 ist der Strom I gemäß dem Stromverlauf 501 größer als 30 A und kleiner als 40 A. Folglich erhöht der erste Zähler 5 gemäß der Fig. 6 seinen Zählerstand Z1 ab dem Zeitpunkt t0. Der zweite Zähler 5 der Fig. 7 erhöht seinen Zählerstand Z2 nicht, da der Strom I gemäß dem Stromverlauf 501 kleiner als der zweite Grenzwert G2 von 40 A ist.

Zum Zeitpunkt t1 fällt der Strom I gemäß dem Stromverlauf 501 unter 30 A. Folglich dekrementiert der erste Zähler 5 der Fig. 6 einen Zählerstand Z1 ab dem Zeitpunkt t1 um ein Dekrement DE.
Ab dem Zeitpunkt t2 ist der Strom I gemäß dem Stromverlauf 501 wieder größer als 30 A und damit größer als der erste Grenzwert G1. Folglich erhöht der erste Zähler 5 der Fig. 6 ab dem Zeitpunkt t2 wieder seinen Zählerstand Z1.
Zum Zeitpunkt t3 übersteigt der Strom I gemäß dem Stromverlauf 501 auch den zweiten Grenzwert G2. Folglich zählt ab dem Zeitpunkt t3 auch der zweite Zähler 5 der Fig. 7 hoch. Dabei wird sein Zählerstand Z2 um das Inkrement IN in jedem Zählintervall erhöht.
Zum Zeitpunkt t4 wird das elektrische Gerät 3 vom Anwender ausgeschaltet. Obwohl zum Zeitpunkt t4 weder der erste Zählerstand Z1 der Fig. 6 seinen Zählergrenzwert T1 noch der zweite Zählerstand Z2 der Fig. 7 seinen Zählergrenzwert T2 erreicht hat, dekrementieren beide Zähler 5 ihre Zählerstände Z1, Z2 um ein doppeltes Dekrement 2DE. Ab dem Zeitpunkt t4 wird zum Dekrementieren das zweifache Dekrement 2DE verwendet, weil der Strom I gemäß dem Stromverlauf 501 Null ist.
Zum Zeitpunkt t5 übersteigt der Strom I gemäß dem Stromverlauf 501 wieder die 30 A. Folglich zählt der erste Zähler 5 der Fig. 6 wieder hoch. Zum Zeitpunkt t6 schaltet der Anwender das elektrische Gerät wieder ab, so dass der erste Zählerstand Z1 der Fig. 6 wieder um das doppelte Dekrement 2DE dekrementiert wird.

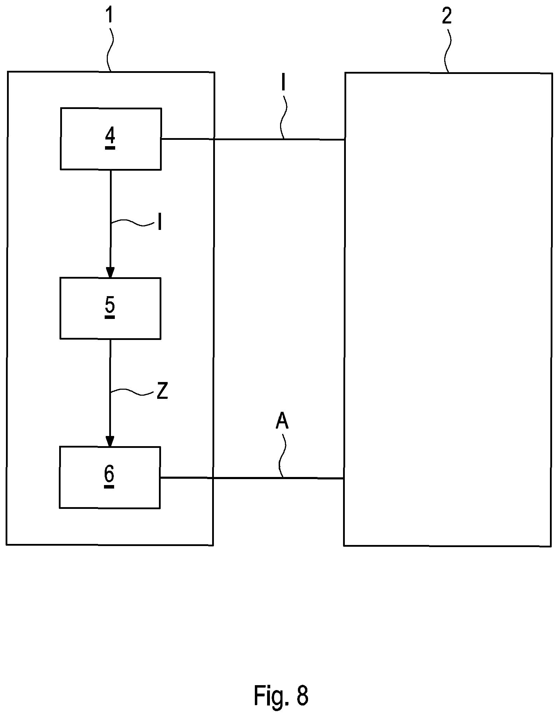

In Fig. 8 ist ein schematisches Blockschaltbild einer Vorrichtung 1 zur Stromüberwachung eines durch eine Batterie 2 betriebenen elektrischen Gerätes 3 dargestellt. Die Vorrichtung 1 hat eine Messeinrichtung 4, einen mit der Messeinrichtung 4 gekoppelten Zähler 5 und eine mit dem Zähler 5 gekoppelte Abschaltvorrichtung 6. Die Messeinrichtung 4 misst den elektrischen Strom I, der der Batterie 2 während des Betriebs des elektrischen Gerätes 3 entnommen wird. Ferner stellt die Messeinrichtung 4 den gemessenen Strom I dem Zähler 5 in einem jeden Zählintervall bereit. Dabei wird der gemessene Strom I beispielsweise als diskreter Wert bereitgestellt. Der Zähler 5 erhöht seinen Zählerstand Z um ein bestimmtes Inkrement IN jeweils dann, wenn der gemessene Strom I innerhalb des bestimmten Zählintervalls größer als ein bestimmter oberer Grenzwert G1, G2 ist. Ferner verringert der Zähler 5 seinen Zählerstand Z um ein bestimmtes Dekrement DE jeweils dann, wenn der gemessene Strom I innerhalb des bestimmten Zählintervalls kleiner als der bestimmte obere Grenzwert G1, G2 ist.

Der Zähler 5 stellt seinen Zählerstand Z der Abschaltvorrichtung 6 bereit. Wenn der Zählerstand Z des Zählers 5 größer als ein bestimmter Zählergrenzwert G1, G2 ist, schaltet die Abschaltvorrichtung 6 das elektrische Gerät 3 ab. Beispielsweise unterbricht die Abschaltvorrichtung 6 die Stromzufuhr von der Batterie 2 an das elektrische Gerät 3. Hierzu verwendet die Abschaltvorrichtung 6 beispielsweise ein Ausschaltsignal A.

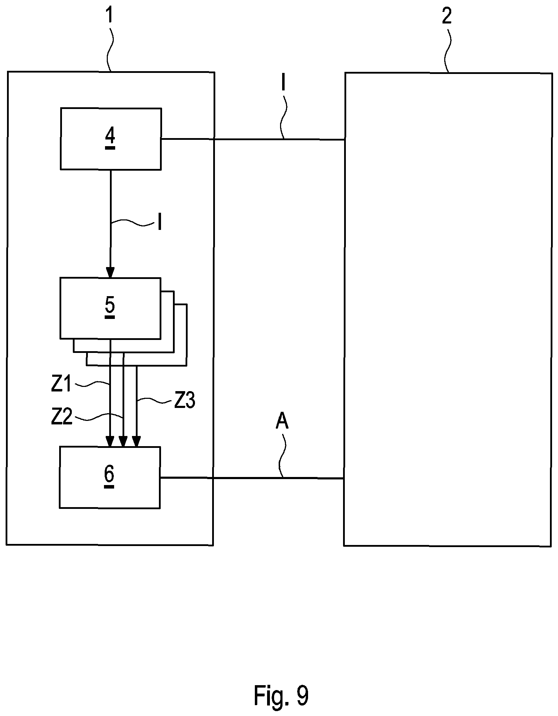

Fig. 9 zeigt ein schematisches Blockschaltbild eines zweiten Ausführungsbeispiels einer Vorrichtung 1 zur Stromüberwachung eines durch eine Batterie 2 betriebenen elektrischen Gerätes 3.

Das zweite Ausführungsbeispiel der Fig. 9 unterscheidet sich von dem ersten Ausführungsbeispiel der Fig. 8 dahingehend, dass eine Mehrzahl von Zählern 5 vorgesehen ist. Ohne Einschränkung der Allgemeinheit zeigt die Fig. 9 drei Zähler 5, die ausgangsseitig einen jeweiligen Zählerstand Z1, Z2, Z3 bereitstellen. Übersteigt einer dieser Zählerstände Z1, Z2, Z3 einen jeweiligen zugeordneten Zählergrenzwert, so schaltet die Abschaltvorrichtung 6 das elektrische Gerät 3 ab.

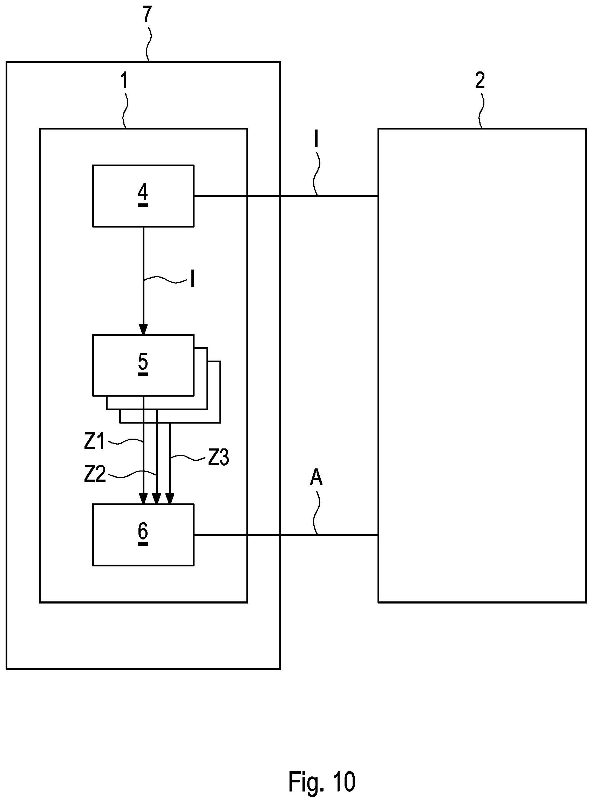

In Fig. 10 ist ein schematisches Blockschaltbild eines Ausführungsbeispiels einer Steuerungsvorrichtung 7 eines elektrischen Gerätes 3 dargestellt. Die Steuerungsvorrichtung 7 weist die Vorrichtung 1 der Fig. 9 auf. Alternativ kann die Steuerungsvorrichtung 7 die Vorrichtung 1 der Fig. 8 aufweisen.

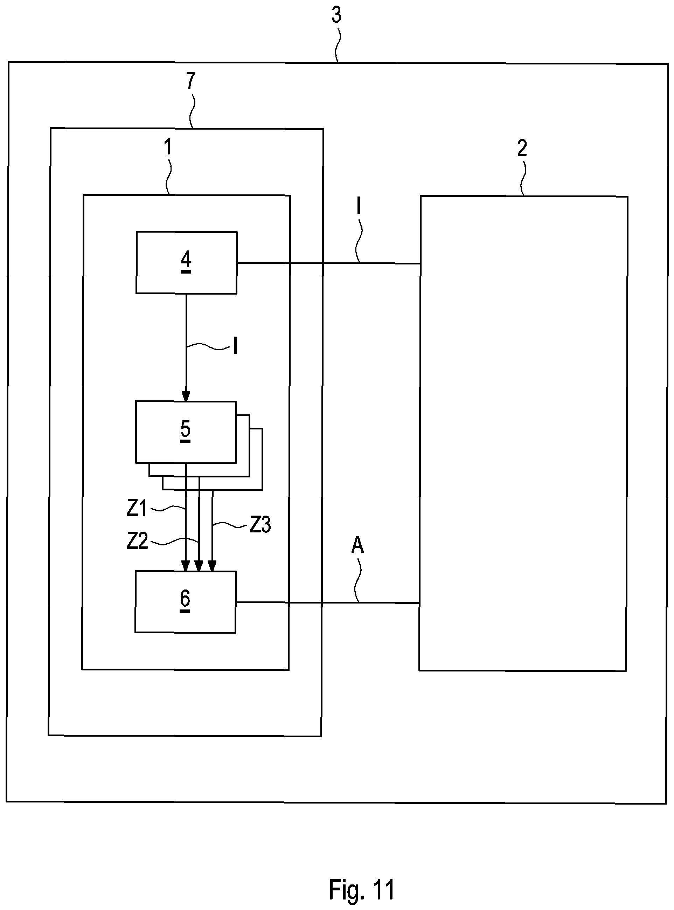

In Fig. 11 ist ein schematisches Blockschaltbild eines Ausführungsbeispiels eines elektrischen Gerätes 3 dargestellt. Das elektrische Gerät 3 weist die Steuerungsvorrichtung 7 der Fig. 10 auf. Das elektrische Gerät 3 ist beispielsweise eine Handwerkzeugmaschine, zum Beispiel ein Elektroschrauber, Bohrmaschine, Bohrhammer, Winkelschleifer, Akku-Handkreissäge. Ferner kann die Vorrichtung 1 auch in der Batterie 2 der Handwerkzeugmaschine integriert sein.

## Patentansprüche

1. Verfahren zur Stromüberwachung einer durch eine Batterie (2) betriebenen elektrischen Handwerkzeugmaschine (3) mittels zumindest eines Zählers (5), mit: a) Messen (S1) des von der Batterie (2) entnommenen elektrischen Stroms (I) während des Betriebs des elektrischen Gerätes (3); b) Inkrementieren (S2) eines Zählerstands (Z, Z1, Z2) des Zählers (5) um ein bestimmtes Inkrement (IN) jeweils dann, wenn der gemessene Strom (I) innerhalb eines bestimmten Zählintervalls größer als ein bestimmter oberer Grenzwert (G1, G2) ist; c) Dekrementieren (S3) des Zählerstands (Z, Z1, Z2) des Zählers (5) um ein bestimmtes Dekrement (DE) jeweils dann, wenn der gemessene Strom (I) innerhalb des bestimmten Zählintervalls kleiner als der bestimmte obere Grenzwert (G1, G2) ist; und d) Abschalten (S4) des elektrischen Gerätes (3), wenn der Zählerstand (Z, Z1, Z2) des Zählers (5) größer als ein bestimmter Zählergrenzwert (T1, T2) ist,
**dadurch gekennzeichnet, dass** eine Mehrzahl von Zählern (5) bereitgestellt wird, wobei dem jeweiligen Zähler (5) ein bestimmtes Inkrement (IN), ein bestimmtes Dekrement (DE), ein bestimmtes Zählintervall, ein bestimmter oberer Grenzwert (G1, G2) und ein bestimmter Zählergrenzwert (T1, T2) zugeordnet wird.

2. Verfahren nach Anspruch 1,
**dadurch gekennzeichnet, dass** die Schritte b) bis d) für einen jeden Zähler (5) der Mehrzahl von Zählern (5) durchgeführt wird (S2-S4).

3. Verfahren nach einen der vorhergehenden Ansprüche,
**dadurch gekennzeichnet, dass** der Zählerstand (Z, Z1, Z2) des Zählers (5) um zumindest das Doppelte (2DE) des bestimmten Dekrements (DE) dekrementiert wird, wenn der gemessene Strom (I) innerhalb des bestimmten Zählintervalls kleiner als ein bestimmter unterer Grenzwert ist (S3).

4. Verfahren nach Anspruch 3,
**dadurch gekennzeichnet, dass** das der Zählerstand (Z, Z1, Z2) des Zählers (5) um das Doppelte (2DE) des bestimmten Dekrements (DE) dekrementiert wird, wenn der gemessene Strom (I) innerhalb des bestimmten Zählintervalls kleiner als der untere Grenzwert (G1, G2) und größer Null ist, und dass der Zählerstand (Z, Z1, Z2) des Zählers (5) um das Dreifache des bestimmten Dekrements (DE) dekrementiert wird, wenn der gemessene Strom (I) innerhalb des bestimmten Zählintervalls Null ist (S3).

5. Verfahren nach einen der vorhergehenden Ansprüche,
**dadurch gekennzeichnet, dass** das Zählintervall zwischen 0,25 ms und 50 ms liegt.

6. Verfahren nach einem der vorhergehenden Ansprüche,
**dadurch gekennzeichnet, dass** der obere Grenzwert (G1, G2) in Abhängigkeit der C-Rate der Batterie (2) bestimmt wird.

7. Vorrichtung (1) zur Stromüberwachung eines durch eine Batterie (2) betriebenen elektrischen Gerätes (3), mit: einer Messeinrichtung (4) zum Messen des von der Batterie (2) entnommenen elektrischen Stroms (I) während des Betriebs des elektrischen Gerätes (3); zumindest einem Zähler (5), der dazu eingerichtet ist, seinen Zählerstand (Z, Z1, Z2) um ein bestimmtes Inkrement (IN) jeweils dann zu inkrementieren, wenn der gemessene Strom (I) innerhalb eines bestimmten Zählintervalls größer als ein bestimmter oberer Grenzwert (G1, G2) ist, und um ein bestimmtes Dekrement (DE) jeweils dann zu dekrementieren, wenn der gemessene Strom (I) innerhalb des bestimmten Zählintervalls kleiner als der bestimmte obere Grenzwert (G1, G2) ist; und einer Abschaltvorrichtung (6) zum Abschalten des elektrischen Gerätes (3), wenn der Zählerstand (Z, Z1, Z2) des Zählers (5) größer als ein bestimmter Zählergrenzwert (T1, T2) ist
**dadurch gekennzeichnet, dass** eine Mehrzahl von Zählern (5) vorgesehen ist, wobei dem jeweiligen Zähler (5) ein bestimmtes Inkrement (IN), ein bestimmtes Dekrement (DE), ein bestimmtes Zählintervall, ein bestimmter oberer Grenzwert (G1, G2) und ein bestimmter Zählergrenzwert (T1, T2) zugeordnet wird, wobei die Abschaltvorrichtung (6) das elektrische Gerät (3) abschaltet, wenn zumindest ein Zählerstand (Z, Z1, Z2) größer als sein bestimmter Zählergrenzwert (T1, T2) ist.

8. Vorrichtung nach Anspruch 7,
**dadurch gekennzeichnet, dass** der Zähler (5) dazu eingerichtet ist, seinen Zählerstand (Z, Z1, Z2) um zumindest das Doppelte (2DE) des bestimmten Dekrements (DE) zu dekrementieren, wenn der gemessene Strom (I) innerhalb des bestimmten Zählintervalls kleiner als ein bestimmter unterer Grenzwert (G1, G2) ist.

9. Vorrichtung nach Anspruch 8,
**dadurch gekennzeichnet, dass** der Zähler (5) dazu eingerichtet ist, seinen Zählerstand (Z, Z1, Z2) um das Doppelte (2DE) des bestimmten Dekrements (DE) zu dekrementieren, wenn der gemessene Strom (I) innerhalb des bestimmten Zählintervalls kleiner als der untere Grenzwert (G1, G2) und größer Null ist, und seinen Zählerstand (Z, Z1, Z2) um das Dreifache des bestimmten Dekrements (DE) zu dekrementieren, wenn der gemessene Strom (I) innerhalb des bestimmten Zählintervalls Null ist.

10. Vorrichtung nach einem der vorhergehenden Ansprüche 7 bis 9,
**dadurch gekennzeichnet, dass** das Zählintervall zwischen 0,25 ms und 50 ms liegt.

11. Vorrichtung nach einem der vorhergehenden Ansprüche 7 bis 10,
**dadurch gekennzeichnet, dass** der obere Grenzwert (G1, G2) in Abhängigkeit der C-Rate der Batterie (2) bestimmt wird.

12. Steuervorrichtung (7) zum Steuern eines durch eine Batterie (2) betriebenen elektrischen Gerätes (3), welche eine Vorrichtung (1) zur Stromüberwachung des elektrischen Gerätes (3) nach einem der Ansprüche 7 bis 11 aufweist.

13. Handwerkzeugmaschine (3) mit einer Vorrichtung (1) zur Stromüberwachung des elektrischen Gerätes (3) nach einem der Ansprüche 7 bis 11.

## Claims

1. Method for monitoring the current of an electrical hand machine tool (3) operated by a battery (2) by means of at least one counter (5), with: a) measuring (S1) of the electrical current (I) taken from the battery (2) during operation of the electrical device (3); b) incrementing (S2) of a counter reading (Z, Z1, Z2) of the counter (5) by a certain increment (IN), if the measured current (I) within a certain counting interval is greater than a certain upper limit value (G1, G2); c) decrementing (S3) of the counter reading (Z, Z1, Z2) of the counter (5) by a certain decrement (DE) if the measured current (I) within the certain counting interval is smaller than the certain upper limit value (G1, G2); and d) switching off (S4) of the electrical device (3), if the counter reading (Z, Z1, Z2) of the counter (5) is greater than a certain counter limit value (T1, T2),
**characterised in that** a multiplicity of counters (5) is provided, in which a certain increment (IN), a certain decrement (DE), a certain counting interval, a certain upper limit value (G1, G2) and a certain counter limit value (T1, T2) is allocated to the relevant counter (5).

2. Method according to claim 1,
**characterised in that** steps b) to d) are carried out for each counter (5) of the multiplicity of counters (5) (S2-S4).

3. Method according to one of the previous claims,
**characterised in that** the counter reading (Z, Z1, Z2) of the counter (5) is decremented by at least double (2DE) the certain decrement (DE), if the measured current (I) within the certain counting interval is smaller than a certain lower limit value (S3).

4. Method according to claim 3,
**characterised in that** the counter reading (Z, Z1, Z2) of the counter (5) is decremented by double (2DE) the certain decrement (DE), if the measured current (I) within the certain counting interval is smaller than the lower limit value (G1, G2) and greater than zero, and the counter reading (Z, Z1, Z2) of the counter (5) is decremented by three times the certain decrement (DE), if the measured current (I) within the certain counting interval is zero (S3).

5. Method according to one of the previous claims,
**characterised in that** the counting interval is between 0.25 ms and 50 ms.

6. Method according to one of the previous claims,
**characterised in that** the upper limit value (G1, G2) is determined depending on the C-rate of the battery (2).

7. Device (1) for monitoring the current of an electrical device (3) operated by a battery (2), with: a measuring device (4) for measuring the electrical current (I) taken from the battery (2) during operation of the electrical device (3); at least one counter (5), which is set up to increment its counter reading (Z, Z1, Z2) by a certain increment (IN), if the measured current (I) within a certain counting interval is greater than a certain upper limit value (G1, G2), and to decrement it by a certain decrement (DE), if the measured current (I) within the certain counting interval is smaller than the certain upper limit value (G1, G2); and a switching off device (6) for switching off the electrical device (3), if the counter reading (Z, Z1, Z2) of the counter (5) is greater than a certain counter limit value (T1, T2)
**characterised in that** a multiplicity of counters (5) is provided, in which a certain increment (IN), a certain decrement (DE), a certain counting interval, a certain upper limit value (G1, G2) and a certain counter limit value (T1, T2) is allocated to the relevant counter (5), in which the switching off device (6) switches off the electrical device (3), if at least one counter reading (Z, Z1, Z2) is greater than its certain counter limit value (T1, T2).

8. Device according to claim 7,
**characterised in that** the counter (5) is set up to decrement its counter reading (Z, Z1, Z2) by at least double (2DE) the certain decrement (DE), if the measured current (I) within the certain counting interval is smaller than a certain lower limit value (G1, G2).

9. Device according to claim 8,
**characterised in that** the counter (5) is set up to decrement its counter reading (Z, Z1, Z2) by double (2DE) the certain decrement (DE), if the measured current (I) within the certain counting interval is smaller than the lower limit value (G1, G2) and greater than zero, and to decrement its counter reading (Z, Z1, Z2) by three times the certain decrement (DE), if its measured current (I) within the certain counting interval is zero.

10. Device according to one of previous claims 7 to 9,
**characterised in that** the counting interval is between 0.25 ms and 50 ms.

11. Device according to one of previous claims 7 to 10,
**characterised in that** the upper limit value (G1, G2) is determined depending on the C-rate of the battery (2).

12. Control device (7) for controlling an electrical device (3) operated by a battery (2), which has a device (1) for monitoring the current of the electrical device (3) according to one of claims 7 to 11.

13. Hand machine tool (3) with a device (1) for monitoring the current of the electrical device (3) according to one of claims 7 to 11.

## Revendications

1. Procédé destiné à surveiller le courant d'une machine-outil électrique manuelle (3) fonctionnant sur une batterie (2), au moyen d'au moins un compteur (5), comportant les étapes consistant à : a) mesurer (S1) le courant électrique (I) prélevé par la batterie (2) pendant le fonctionnement de l'appareil électrique (3), b) incrémenter (S2) une indication de compteur (Z, Z1, Z2) du compteur (5) d'un incrément (IN) déterminé chaque fois que le courant (I) mesuré sur un intervalle de comptage déterminé est supérieur à une valeur limite supérieure (G1, G2) déterminée, c) décrémenter (S3) l'indication de compteur (Z, Z1, Z2) du compteur (5) d'un décrément (DE) déterminé chaque fois que le courant (I) mesuré sur l'intervalle de comptage déterminé est inférieur à la valeur limite supérieure (G1, G2) déterminée, et d) arrêter (S4) l'appareil électrique (3) lorsque l'indication de compteur (Z, Z1, Z2) du compteur (5) est supérieure à une valeur limite de compteur (T1, T2) déterminée,
**caractérisé en ce qu'**une pluralité de compteurs (5) est fournie, dans lequel un incrément (IN) déterminé, un décrément (DE) déterminé, un intervalle de comptage déterminé, une valeur limite supérieure (G1, G2) déterminée et une valeur limite de compteur (T1, T2) déterminée sont associés au compteur (5) respectif.

2. Procédé selon la revendication 1,
**caractérisé en ce que** les étapes b) à d) sont exécutées (S2 à S4) pour chaque compteur (5) de la pluralité de compteurs (5).

3. Procédé selon l'une des revendications précédentes,
**caractérisé en ce que** l'indication de compteur (Z, Z1, Z2) du compteur (5) est décrémentée d'une valeur au moins égale au double (2DE) du décrément (DE) déterminé, lorsque le courant (I) mesuré sur l'intervalle de comptage déterminé est inférieur à une valeur limite inférieure (S3) déterminée.

4. Procédé selon la revendication 3,
**caractérisé en ce que** l'indication de compteur (Z, Z1, Z2) du compteur (5) est décrémentée d'une valeur égale au double (2DE) du décrément (DE) déterminé, lorsque le courant (I) mesuré sur l'intervalle de comptage déterminé est inférieur à la valeur limite inférieure (G1, G2) et est supérieur à zéro, et **en ce que** l'indication de compteur (Z, Z1, Z2) du compteur (5) est décrémentée d'une valeur égale au triple du décrément (DE) déterminé, lorsque le courant (I) mesuré sur l'intervalle de comptage déterminé est égal à zéro (S3).

5. Procédé selon l'une des revendications précédentes,
**caractérisé en ce que** l'intervalle de comptage est compris entre 0,25 ms et 50 ms.

6. Procédé selon l'une des revendications précédentes,
**caractérisé en ce que** la valeur limite supérieure (G1, G2) est déterminée en fonction du facteur C de la batterie (2).

7. Dispositif (1) destiné à surveiller le courant d'un appareil électrique (3) fonctionnant sur une batterie (2) comportant : un dispositif de mesure (4) pour mesurer le courant électrique (I) prélevé par la batterie (2) pendant le fonctionnement de l'appareil électrique (3), au moins un compteur (5) configuré pour incrémenter son indication de compteur (Z, Z1, Z2) d'un incrément (IN) déterminé chaque fois que le courant (I) mesuré sur un intervalle de comptage déterminé est supérieur à une valeur limite supérieure (G1, G2) déterminée, et pour la décrémenter d'un décrément (DE) déterminé chaque fois que le courant (I) mesuré sur l'intervalle de comptage déterminé est inférieur à la valeur limite supérieure (G1, G2) déterminée, et un dispositif de coupe-circuit (6) pour arrêter l'appareil électrique (3) lorsque la valeur de comptage (Z, Z1, Z2) du compteur (5) est supérieure à une valeur limite de compteur (T1, T2) déterminée,
**caractérisé en ce qu'**une pluralité de compteurs (5) est prévue, dans lequel un incrément (IN) déterminé, un décrément (DE) déterminé, un intervalle de comptage déterminé, une valeur limite supérieure (G1, G2) déterminée et une valeur limite de compteur (T1, T2) déterminée sont associés au compteur (5) respectif, dans lequel le dispositif de coupe-circuit (6) arrête l'appareil électrique (3) lorsqu'au moins une indication de compteur (Z, Z1, Z2) est supérieure à sa valeur limite de compteur (T1, T2) déterminée.

8. Dispositif selon la revendication 7,
**caractérisé en ce que** le compteur (5) est configuré pour décrémenter son indication de compteur (Z, Z1, Z2) d'une valeur au moins égale au double (2DE) du décrément (DE) déterminé, lorsque le courant (I) mesuré sur l'intervalle de comptage déterminé est inférieur à une valeur limite inférieure (G1, G2) déterminée.

9. Dispositif selon la revendication 8,
**caractérisé en ce que** le compteur (5) est configuré pour décrémenter son indication de compteur (Z, Z1, Z2) d'une valeur égale au double (2DE) du décrément (DE) déterminé, lorsque le courant (I) mesuré sur l'intervalle de comptage déterminé est inférieur à la valeur limite inférieure (G1, G2) et est supérieur à zéro, et pour décrémenter son indication de compteur (Z, Z1, Z2) d'une valeur égale au triple du décrément (DE) déterminé, lorsque le courant (I) mesuré sur l'intervalle de comptage déterminé est égal à zéro.

10. Dispositif selon l'une des revendications 7 à 9 précédentes,
**caractérisé en ce que** l'intervalle de comptage est compris entre 0,25 ms et 50 ms.

11. Dispositif selon l'une des revendications 7 à 10 précédentes,
**caractérisé en ce que** la valeur limite supérieure (G1, G2) est déterminée en fonction du facteur C de la batterie (2).

12. Dispositif de commande (7) pour commander un appareil électrique (3) fonctionnant sur une batterie (2), lequel dispositif de commande comporte un dispositif (1) de surveillance de courant de l'appareil électrique (3) selon l'une des revendications 7 à 11.

13. Machine-outil manuelle (3) ayant un dispositif (1) de surveillance de courant de l'appareil électrique (3) selon l'une des revendications 7 à 11.
